# EUROPEAN PATENT APPLICATION

(11) **EP 4 844 527 A1**
(43) Date of publication of application: **25.11.2026**
(21) Application number: 25216505.5
(22) Date of filing: 18.11.2025
(51) Int. Cl.: G05F 3/26, H10D 10/01, H10D 10/80, H10D 62/10, H10D 84/01

(54) **CURRENT MIRRORS**

(30) Priority: 21.05.2025 US 202519214565
(71) Applicant: GlobalFoundries U.S. Inc., Malta, NY 12020 (US)
(72) Inventor: SHANK, STEVEN M., Malta, 12020 (US); RAGHUNATHAN, UPPILI SRINIVASAN, Malta, 12020 (US); VANUKURU, VENKATA NARAYANA RAO, Malta, 12020 (US); VALLETT, AARON LEE, Malta, 12020 (US)
(74) Representative: Grünecker Patent- und Rechtsanwälte PartG mbB

(57) **Abstract**

The present disclosure relates to semiconductor structures and, more particularly, to current mirrors and methods of manufacture. The structure includes: a reference transistor of a current mirror; at least one output transistor of the current mirror; a shared extrinsic base region across the reference transistor and the at least one output transistor; and a shared emitter region across the reference transistor and the at least one output transistor.

## Description

### BACKGROUND

The present disclosure relates to semiconductor structures and, more particularly, to current mirrors and methods of manufacture.

A current mirror is a circuit designed to copy a current through one active device by controlling the current in another active device of a circuit, keeping the output current constant regardless of loading. The current being "copied" can be, for example, a varying signal current. The current mirror is used to provide bias currents and active loads to circuits. It can also be used to model a more realistic current source.

Current mirrors may be co-integrated with SiGe HBTs for compact circuits, such as amplifiers, such that across chip and chip-to-chip variability and mismatch is minimized or eliminated (ideal mirroring case). Also such current mirrors eliminate the need for "over-design" (results in higher currents, larger areas).

### SUMMARY

In an aspect of the disclosure, a structure comprises: a reference transistor of a current mirror; at least one output transistor of the current mirror; a shared extrinsic base region across the reference transistor and the at least one output transistor; and a shared emitter region across the reference transistor and the at least one output transistor.

In an aspect of the disclosure, a structure comprises: a current mirror comprising a first heterojunction bipolar transistor and a second heterojunction bipolar transistor; a common extrinsic base region to the first heterojunction bipolar transistor and the second heterojunction bipolar transistor; a common emitter region to the first heterojunction bipolar transistor and the second heterojunction bipolar transistor; a first contact shorting the common extrinsic base region to a collector region of the first heterojunction bipolar transistor; a second contact connecting the common emitter to ground; and a third contact connecting to a collector region of the second heterojunction bipolar transistor.

In an aspect of the disclosure, a method comprises: forming a reference transistor of a current mirror; forming at least one output transistor of the current mirror; forming a shared extrinsic base region across the reference transistor and the at least one output transistor; and forming a shared emitter region across the reference transistor and the at least one output transistor.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a current mirror and respective fabrication processes in accordance with aspects of the present disclosure.
FIGS. 2-5 show additional current mirrors in accordance with further aspects of the present disclosure.

### DETAILED DESCRIPTION

The present disclosure relates to semiconductor structures and, more particularly, to current mirrors and methods of manufacture. Advantageously, the current mirrors described herein provide improved V_{be} (e.g., temperature dependence) using a shared extrinsic base, with a stable reference current (e.g., (I1): I2 (Iout) = I1a) and very small current transfer ratio. Moreover, the current mirrors provide improved saturation current (dimensional parameters) compared to the use of two distinct heterojunction bipolar transistors. The current mirrors also provide significant area savings.

In embodiments, the current mirrors comprise heterojunction bipolar transistors (HBT) with a continuous (e.g., shared) extrinsic base and a continuous emitter layer across a reference HBT and one or more output HBTs. The continuous extrinsic base layer includes a boron doped polysilicon material. A contact shorts the extrinsic base to collector on the reference HBT. The current mirrors also include a continuous Si epitaxial layer between the two or more HBTs, which becomes part of extrinsic base. The collectors and sub-collectors may be isolated from each of the HBTs. The HBTs described herein can be either NPN or PNP base current mirrors. In addition, the output HBTs may be different emitter lengths.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

Examples of various epitaxial growth process apparatuses that can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used. A dopant (n-type or p-type, as defined below) is typically added to the precursor gas or gas mixture. Also, as should be understood by those of skill in the art, the epitaxial growth processes can be selective or non-selective as is known in the art such that no further explanation is required for a complete understanding of the present disclosure.

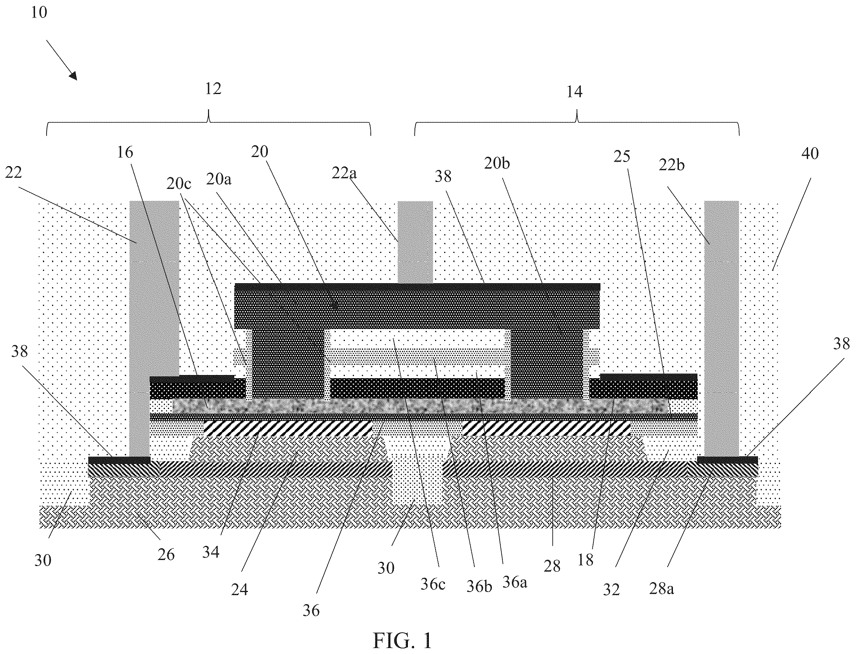

FIG. 1 shows a current mirror and respective fabrication processes in accordance with aspects of the present disclosure. In embodiments, the current mirror 10 includes a reference transistor 12 and a output transistor 14. In embodiments, the reference transistor 12 and the output transistor 14 may be HBTs. The HBTs 12, 14 comprise a continuous (e.g., shared) extrinsic base 18 (with semiconductor layer 16) and continuous emitter layer 20 across the reference HBT 12 and the output HBT 14. The continuous extrinsic base 18 may be a boron doped polysilicon material, with an underlying continuous and shared boron doped epitaxial Si layer 16 between the two or more HBTs 12, 14. The continuous and shared boron doped epitaxial Si layer 16 also becomes part of the extrinsic base. A contact 22 shorts the extrinsic base 18 to a collector region 24 on the reference HBT 12.

More specifically, the current mirror 10 includes a semiconductor substrate 26. In embodiments, the semiconductor substrate 26 may be composed of any suitable material including, but not limited to, Si, SiGe, SiGeC, SiC, GaAs, InAs, InP, and other III/V or II/VI compound semiconductors. The semiconductor substrate 26 may comprise any suitable crystallographic orientation (e.g., a (100), (110), (111), or (001) crystallographic orientation).

A sub-collector region 28 may be formed on the semiconductor substrate 26. In embodiments, the sub-collector region 28 may be, for example, N-doped Si material. The sub-collector region 28 may also have contact regions 28a, which are heavily N-doped regions. In embodiments, the sub-collector region 28 may be formed by an epitaxial growth process with an in-situ doping, e.g., n-type dopants, e.g., Arsenic (As), Phosphorus (P) and Antimony (Sb), among other suitable examples.

FIG. 1 further shows a shallow trench isolation region 30 extending through the sub-collector region 28 and into the underlying semiconductor substrate 26. The shallow trench isolation region 30 also isolates the sub-collector regions 28 of the HBTs 12, 14. The shallow trench isolation region 30 may be formed by conventional lithography, etching and deposition methods known to those of skill in the art.

For example, a resist formed over the sub-collector region 28 is exposed to energy (light) and developed to form a pattern (opening). An etching process with a selective chemistry, e.g., reactive ion etching (RIE), will be used to transfer the pattern from the patterned photoresist layer to the sub-collector region 28 and the underlying semiconductor substrate 26 to form one or more trenches. Following the resist removal by a conventional oxygen ashing process or other known stripants, insulator material (e.g., silicon oxide) can be deposited by any conventional deposition processes, e.g., chemical vapor deposition (CVD) processes. Any residual material on the surface of the sub-collector region 28 can be removed by conventional chemical mechanical polishing (CMP) processes. An additional patterned insulator material 32 (e.g., silicon oxide) may be provided over the sub-collector region 28.

A semiconductor material 24 may be formed over the sub-collector region 28 and between patterned insulator material 32. In embodiments, the semiconductor material 24 may be a collector region for the HBTs 12, 14. The semiconductor material 24 may be undoped epitaxial Si material. In embodiments, the semiconductor material 24 may also be n-doped though out diffusion of the underlying sub-collector region 28.

An intrinsic base region 34 may be provided on the semiconductor material 24. In embodiments, the intrinsic base region 34 may be p-doped SiGe material, which may be formed by an epitaxial growth process. The intrinsic base region 34 may be separated by insulator material 36 over the shallow trench isolation structures 30 and between the two HBT 12, 14. The insulator material 36 may be silicon nitride or silicon dioxide deposited by a conventional deposition process, e.g., CVD. An undoped semiconductor material 25 may be formed by an epitaxial growth process on the intrinsic base region 34 and insulator material 36.

A continuous layer of semiconductor material 16 may be formed over the intrinsic base region 34 and, more specifically, over the undoped semiconductor material 25. The semiconductor material 16 may be epitaxially grown Si material. In more specific embodiments, the semiconductor material 16 may be p-doped (e.g., boron ) semiconductor material, e.g., Si, epitaxially grown with an in-situ doping process. The semiconductor material 16 may form part of the extrinsic base region 18. In embodiments, the semiconductor material 16 may be a continuous semiconductor layer extending between the reference HBT 12 and the output HBT 14.

The extrinsic base region 18 may be formed over the continuous layer of semiconductor material 16. The extrinsic base region 18 may be polysilicon material. In more specific embodiments, the polysilicon material might be P-doped polysilicon material. The extrinsic base region 18 may be provided beyond ends of the emitter layer 20. In this way, a contact 22 may be used to contact the extrinsic base region 18 and the collector region 24 for the reference HBT 12.

FIG. 1 further shows the emitter layer 20 extending to and contacting the intrinsic base, e.g., the semiconductor material 16. The emitter layer 20 may be shared between the reference HBT 12 and the output HBT 14. For example, the emitter layer 20 may include a bridge feature 20a and two legs 20b extending to and contacting the semiconductor material 16. In embodiments, the emitter layer 20 may be n-type polysilicon material.

Insulator material 36a, 36b, 36c may be formed under the bridge feature 20a and between the two legs 20b. The insulator material 36a, 36b, 36c may be, for example, alternating layers of SiO₂ and SiN, one of which can also be used to form sidewall spacers 20c on the inner and outer walls of the two legs 20b of the emitter layer 20. The extrinsic base 18 may be between and outside of the legs 20b. As should be understood by those of skill in the art, the bridge feature 20a and the legs 20b may be formed by deposition and patterning of the insulator material 36a, 36b, 36c and the semiconductor material of the extrinsic base region 18 to expose the underlying semiconductor material 16, followed by a polysilicon CVD process to form the legs 20b and the bridge feature 20a.

Silicide contacts 38 may be formed on the emitter layer 20, the extrinsic base region 18 and to the heavily doped regions 28a (of both the HBTs 12, 14) connecting to the collector region 24. As should be understood by those of skill in the art, the silicide process begins with deposition of a thin transition metal layer, e.g., nickel, cobalt or titanium, over fully formed and patterned semiconductor layers. After deposition of the material, the structure is heated allowing the transition metal to react with exposed silicon (or other semiconductor material as described herein) in the active regions of the semiconductor device (e.g., source, drain, gate contact region) forming a low-resistance transition metal silicide. Following the reaction, any remaining transition metal is removed by chemical etching, leaving silicide contacts 38 in the active regions of the device.

Contacts 22, 22a, 22b may be formed to the silicide contacts 38. The contacts 22, 22a, 22b may be tungsten or other conductive materials as is known in the art. The contact 22 may be formed on the extrinsic base region 18 and to the heavily doped regions 28a (collector region 24 of the reference HBT 12). As should be understood, the contact 22 will also connect to V1. The contact 22a may be formed to the emitter layer 20 common to both the reference HBT 12 and the output HBT 14. In embodiments, the contact 22a may also contact ground. The contact 22b may be formed to the heavily doped regions 28a (collector region 24 of the output HBT 14) and V2. As shown, no contact is required to the extrinsic base on the output HBT 14. The shared emitter and base contacts between the two transistors minimizes Re and Vbe mismatch, which allows more accurate mirroring of current (e.g., 60% lower mismatch).

The contacts 22, 22a, 22b may be formed within interlevel dielectric material 40 using conventional lithography, etching and deposition methods as described herein and as is known in the art such that no further explanation is required for a complete understanding of the present disclosure.

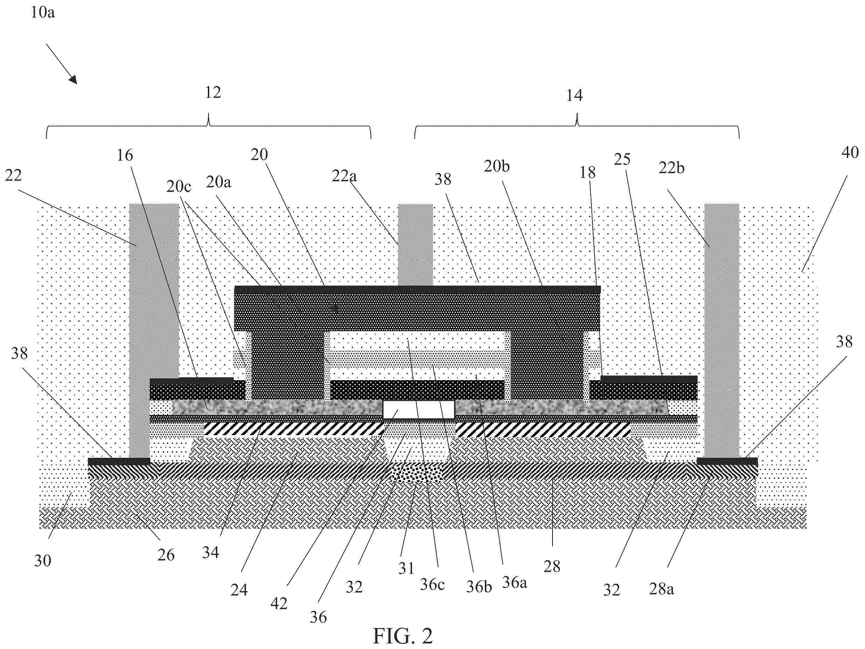

FIG. 2 shows a current mirror in accordance with additional aspects of the present disclosure. The current mirror 10a of FIG. 2 includes an airgap 42 within the semiconductor material 16 (e.g., part of the extrinsic base) and, in embodiments, the semiconductor material 25, between the reference HBT 12 and the output HBT 14. In more specific embodiments, the airgap 42 may be provided over an isolation region 31, e.g., p-type semiconductor material (e.g., Si), and the insulator materials 32, 36 formed within the sub-collector region 28 (which isolates the HBTs 12, 14). In an alternative embodiment, the shallow trench isolation structure of FIG. 1 may be used in this location. In this way, the airgap 42 will divide the semiconductor material 16 (e.g., part of the extrinsic base) into two portions, one for each of the HBTs 12, 14. The airgap 42 may be formed by a selective growth of the semiconductor material 16, followed by the deposition of the extrinsic base region 18 over the airgap 42. As in all of the embodiments described herein, the extrinsic base region 18 will be continuous between the reference HBT 12 and the output HBT 14. The remaining features of the current mirror 10a are similar the current mirror 10 of FIG. 1 such that no further explanation is required for a complete understanding of the present disclosure.

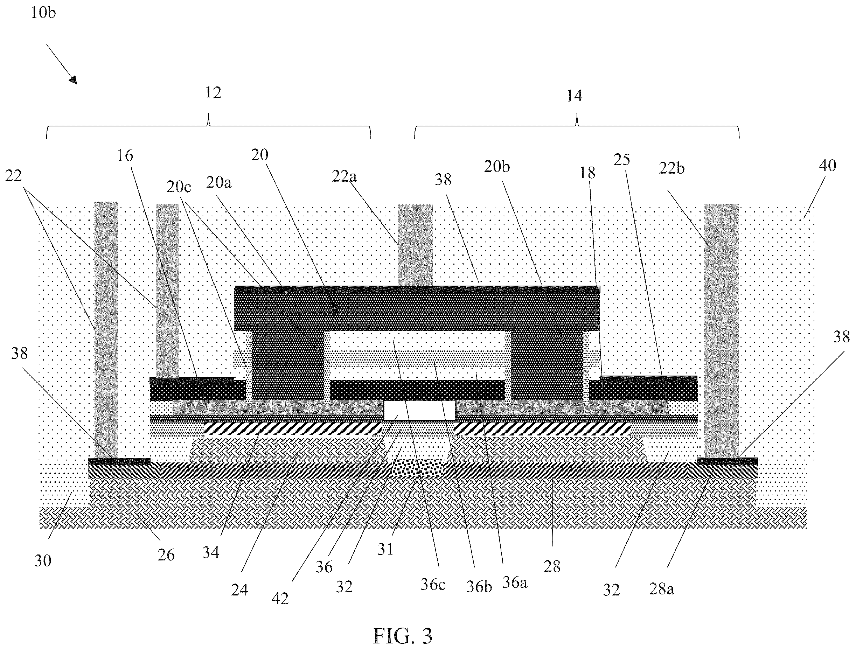

FIG. 3 shows another current mirror in accordance with aspects of the present disclosure. The current mirror 10b of FIG. 3 includes the airgap 42 in addition to separate contacts 22 for the reference HBT 12. Specifically, the separate contacts 22 will separately contact to the extrinsic base region 18 and the collector region 24 (through the heavily doped region 28a). It should also be understood by those of skill in the art that the separate contacts 22 may be provided to a common wiring structure connecting to V1. The remaining features of the current mirror 10b are similar the current mirror 10a of FIG. 2 such that no further explanation is required for a complete understanding of the present disclosure.

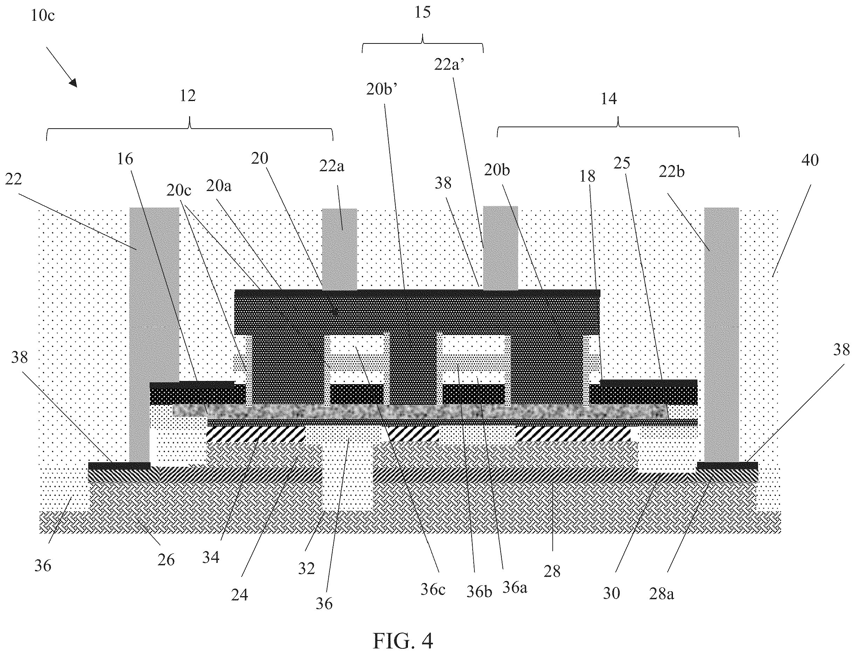

FIG. 4 shows another current mirror in accordance with aspects of the present disclosure. The current mirror 10c of FIG. 4 includes three HBTs 12, 14, 15. In this embodiment, the HBT 12 is the reference HBT and the HBTs 14, 15 are the output HBTs. As in each of the embodiments, the emitter layer 20 is shared amongst the HBTs 12, 14, 15. In this embodiment, though, an additional leg 20b' may be between the HBTs 12, 14. An additional contact 22a'may also be used to connect to the shared emitter layer 20. The contact 22b may be used to contact the collector region 24 of the HBT 14, 15.

Moreover, as shown in FIG. 4, the shallow trench isolation structure 30 and the insulator material 32 may be under the extrinsic base region 18 of the HBT 15; whereas the insulator material 32 (without a shallow trench isolation structure) may be under the extrinsic base region 18 of the HBT 14. In this way, the insulator materials 32, 36 separate portions of the intrinsic base region 34 under the extrinsic base region 18 of the output HBT 14 and the output HBT 15. The remaining features of the current mirror 10c are similar the current mirror 10 of FIG. 1 such that no further explanation is required for a complete understanding of the present disclosure.

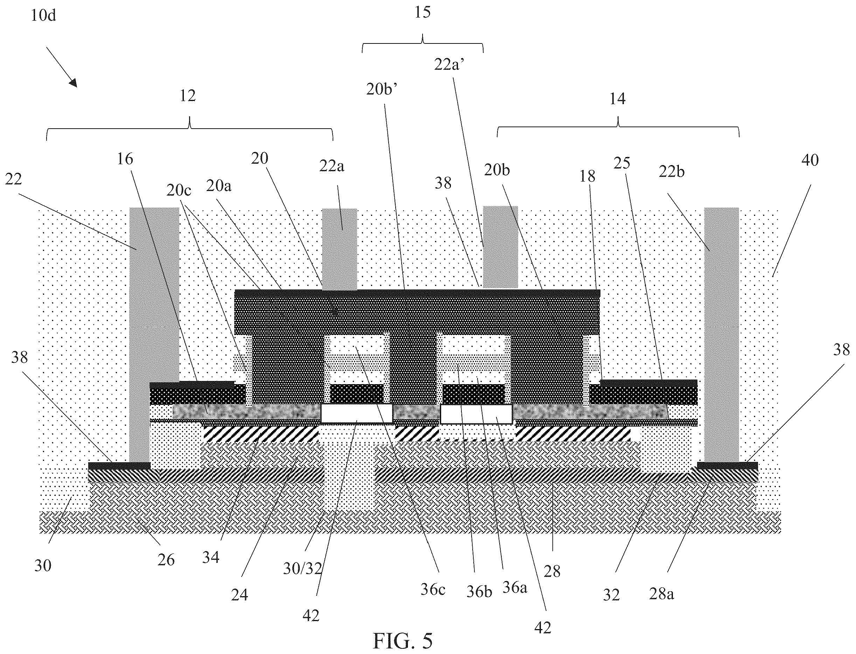

FIG. 5 shows a current mirror 10d similar to the current mirror 10c of FIG. 4. In this embodiment, the current mirror 10d includes the airgaps 42 within the semiconductor material 16 (e.g., part of the extrinsic base) and the semiconductor material 25, between the reference HBT 12 and the output HBTs 14, 15 as described above. The remaining features of the current mirror 10d are similar the current mirror 10c of FIG. 3 and current mirror 10 of FIG. 1 such that no further explanation is required for a complete understanding of the present disclosure.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the present disclosure relates to semiconductor structures and, more particularly, to current mirrors and methods of manufacture. The structure includes: a reference transistor of a current mirror; at least one output transistor of the current mirror; a shared extrinsic base region across the reference transistor and the at least one output transistor; and a shared emitter region across the reference transistor and the at least one output transistor.

The following embodiments are explicitly disclosed.

### Embodiment 1:

A structure comprising:
a reference transistor of a current mirror;
at least one output transistor of the current mirror;
a shared extrinsic base region across the reference transistor and the at least one output transistor; and
a shared emitter region across the reference transistor and the at least one output transistor.

### Embodiment 2:

The structure of embodiment 1, wherein the reference transistor and the at least one output transistor comprise a heterojunction bipolar transistor.

### Embodiment 3:

The structure of embodiment 1 or 2, further comprising a contact of the reference transistor shorting the shared extrinsic base region to a collector region.

### Embodiment 4:

The structure of embodiment 3, wherein the contact comprises a first contact to the shared extrinsic base region and a second contact to the collector region.

### Embodiment 5:

The structure of one of embodiments 1 to 4, preferably of embodiment 3 or 4, further comprising an emitter contact connected between the shared emitter region and ground.

### Embodiment 6:

The structure of one of embodiments 1 to 5, preferably of embodiment 5, further comprising an airgap under the shared extrinsic base region.

### Embodiment 7:

The structure of embodiment 6, wherein the shared extrinsic base region extends over the airgap.

### Embodiment 8:

The structure of one of embodiments 1 to 7, preferably of embodiment 6 or 7, further comprising a collector contact connecting to a collector region of the at least one output transistor.

### Embodiment 9:

The structure of one of embodiments 1 to 8, preferably of embodiment 8, wherein an extrinsic base contact is adjacent to an outer side of the shared emitter region on a side of the reference transistor.

### Embodiment 10:

The structure of one of embodiments 1 to 9, wherein the at least one output transistor comprises two output transistors, and the shared extrinsic base region and shared emitter region are across the reference transistor and the two output transistors.

### Embodiment 11:

The structure of one of embodiments 1 to 10, wherein the shared emitter region comprises connects to an epitaxial semiconductor material under the extrinsic base region.

### Embodiment 12:

A structure comprising:
a current mirror comprising a first heterojunction bipolar transistor and a second heterojunction bipolar transistor;
a common extrinsic base region to the first heterojunction bipolar transistor and the second heterojunction bipolar transistor;
a common emitter region to the first heterojunction bipolar transistor and the second heterojunction bipolar transistor;
a first contact shorting the common extrinsic base region to a collector region of the first heterojunction bipolar transistor;
a second contact connecting the common emitter to ground; and
a third contact connecting to a collector region of the second heterojunction bipolar transistor.

In some special illustrative examples of embodiment 12, the structure embodiment 12 may be represent the structure of one of embodiments 1 to 11, wherein the structure further comprises:
a current mirror comprising a first heterojunction bipolar transistor as the reference transistor and a second heterojunction bipolar transistor as the at least one output transistor,
wherein a common extrinsic base region to the first heterojunction bipolar transistor and the second heterojunction bipolar transistor is provided by the shared extrinsic base region,
wherein a common emitter region to the first heterojunction bipolar transistor and the second heterojunction bipolar transistor is provided by the shared emitter region,
wherein the structure further comprises:
   a first contact shorting the common extrinsic base region to a collector region of the first heterojunction bipolar transistor;
   a second contact connecting the common emitter to ground; and
   a third contact connecting to a collector region of the second heterojunction bipolar transistor. Accordingly, the structure of embodiment 12 may be related back to one of embodiments 1 to 11, the current mirror in embodiment 1 being included into the structure of embodiment 12.

### Embodiment 13:

The structure of embodiment 12, wherein the collector region and a sub-collector region of the first heterojunction bipolar transistor and the second heterojunction bipolar transistor are isolated from one another.

### Embodiment 14:

The structure of embodiment 12 or 13, wherein the first contact comprising an extrinsic base contact connecting to the common extrinsic base region and a collector contact connecting to collector region of the first heterojunction bipolar transistor.

### Embodiment 15:

The structure of one of embodiments 12 to 14, preferably of embodiment 13, further comprising an airgap under the common extrinsic base region.

### Embodiment 16:

The structure of embodiment 15, further comprising doped polysilicon material extending over the airgap.

### Embodiment 17:

The structure of one of embodiments 12 to 16, further comprising a third heterojunction bipolar transistor adjacent to the second heterojunction bipolar transistor and sharing the common emitter region and the common extrinsic base region.

### Embodiment 18:

The structure of one of embodiments 12 to 17, preferably of embodiment 17, wherein the first heterojunction bipolar transistor comprises a reference transistor and the second and third heterojunction bipolar transistors comprise output transistors.

### Embodiment 19:

The structure of one of embodiments 12 to 18, preferably of embodiment 17 or 18, wherein the common extrinsic base region comprising a continuous extrinsic base region.

### Embodiment 20:

A method comprising:
forming a reference transistor of a current mirror;
forming at least one output transistor of the current mirror;
forming a shared extrinsic base region across the reference transistor and the at least one output transistor; and
forming a shared emitter region across the reference transistor and the at least one output transistor.

### Embodiment 21:

The method of embodiment 20, wherein the structure of one of embodiments 1 to 19 is formed.

## Claims

1. A structure comprising:
a reference transistor of a current mirror;
at least one output transistor of the current mirror;
a shared extrinsic base region across the reference transistor and the at least one output transistor; and
a shared emitter region across the reference transistor and the at least one output transistor,
wherein the reference transistor and the at least one output transistor preferably comprise a heterojunction bipolar transistor.

2. The structure of claim 1, further comprising a contact of the reference transistor shorting the shared extrinsic base region to a collector region.

3. The structure of claim 2, wherein the contact comprises a first contact to the shared extrinsic base region and a second contact to the collector region.

4. The structure of one of claims 1 to 3, further comprising an airgap under the shared extrinsic base region.

5. The structure of claim 4, wherein the shared extrinsic base region extends over the airgap.

6. The structure of one of claims 1 to 5, further comprising an emitter contact connected between the shared emitter region and ground.

7. The structure of one of claims 1 to 6, further comprising a collector contact connecting to a collector region of the at least one output transistor.

8. The structure of one of claims 1 to 7, wherein an extrinsic base contact is adjacent to an outer side of the shared emitter region on a side of the reference transistor.

9. The structure of one of claims 1 to 8, wherein the at least one output transistor comprises two output transistors, and the shared extrinsic base region and shared emitter region are across the reference transistor and the two output transistors, and/or
wherein the shared emitter region comprises connects to an epitaxial semiconductor material under the extrinsic base region.

10. The structure of one of claims 1 to 9, further comprising:
a current mirror comprising a first heterojunction bipolar transistor as the reference transistor and a second heterojunction bipolar transistor as the at least one output transistor,
wherein a common extrinsic base region to the first heterojunction bipolar transistor and the second heterojunction bipolar transistor is provided by the shared extrinsic base region,
wherein a common emitter region to the first heterojunction bipolar transistor and the second heterojunction bipolar transistor is provided by the shared emitter region,
wherein the structure further comprises:
a first contact shorting the common extrinsic base region to a collector region of the first heterojunction bipolar transistor;
a second contact connecting the common emitter to ground; and
a third contact connecting to a collector region of the second heterojunction bipolar transistor.

11. The structure of claim 10, wherein the collector region and a sub-collector region of the first heterojunction bipolar transistor and the second heterojunction bipolar transistor are isolated from one another, and/or
wherein the first contact comprising an extrinsic base contact connecting to the common extrinsic base region and a collector contact connecting to collector region of the first heterojunction bipolar transistor, and/or
wherein the common extrinsic base region comprising a continuous extrinsic base region.

12. The structure of claim 10 or 11, further comprising an airgap under the common extrinsic base region,
wherein the structure preferably further comprises doped polysilicon material extending over the airgap.

13. The structure of one of claims 10 to 12, further comprising a third heterojunction bipolar transistor adjacent to the second heterojunction bipolar transistor and sharing the common emitter region and the common extrinsic base region.

14. The structure of claim 13, wherein the first heterojunction bipolar transistor comprises a reference transistor and the second and third heterojunction bipolar transistors comprise output transistors.

15. A method comprising:
forming a reference transistor of a current mirror;
forming at least one output transistor of the current mirror;
forming a shared extrinsic base region across the reference transistor and the at least one output transistor; and
forming a shared emitter region across the reference transistor and the at least one output transistor.
